# DEMANDE DE BREVET EUROPEEN

(11) **EP 4 020 475 A1**
(43) Date de publication de la demande: **29.06.2022**
(21) Numéro de dépôt: 21216400.8
(22) Date de dépôt: 21.12.2021
(51) Int. Cl.: G11C 7/10

(54) **MODULE MÉMOIRE ADAPTÉ À METTRE EN OEUVRE DES FONCTIONS DE CALCUL**

(30) Priorité: 28.12.2020 FR 2014174
(71) Demandeur: Commissariat à l'Energie Atomique et aux Energies Alternatives, 75015 Paris (FR)
(72) Inventeur: KOOLI, Maha, 38054 Grenoble Cedex 09 (FR); GAUCHI, Roman, 38054 Grenoble Cedex 09 (FR); VIVET, Pascal, 38054 Grenoble Cedex 09 (FR)
(74) Mandataire: Cabinet Beaumont

(57) **Abrégé**

La présente description concerne un dispositif mémoire (200) comportant : un circuit mémoire (201) mettant en œuvre des opérations et réalisant des opérations élémentaires incluant une lecture, une écriture ou un calcul ; un circuit (205) de contrôle recevant des instructions d'un processeur (231), et décomposant chaque instruction reçue en plusieurs opérations élémentaires de façon à générer un flux de requête d'opérations élémentaires ; un circuit (203) de transfert direct de données depuis ou vers ledit circuit mémoire (201), le circuit de transfert (203) recevant des instructions du processeur (231), décomposant chaque instruction reçue en plusieurs opérations élémentaires à réaliser dans ledit circuit mémoire de façon à générer un flux de requête d'opérations élémentaires ; une liaison interne (204) d'échange de données reliant directement ledit circuit mémoire (201) au circuit de transfert direct (203) ; et un circuit d'arbitrage (309).

## Description

### Domaine technique

La présente description concerne de façon générale le domaine des circuits mémoire, et vise plus particulièrement le domaine des circuits mémoire adaptés à mettre en oeuvre des opérations de calcul.

### Technique antérieure

On a déjà proposé des circuits mémoire adaptés à mettre en oeuvre des opérations de calcul, ou circuit mémoire « intelligents » (souvent appelé « smart memory » en anglais). De tels circuits sont par exemple destinés à coopérer avec un processeur, de façon à décharger le processeur de certaines tâches de calcul.

Néanmoins, les données utilisées pour les opérations de calcul demandées par un processeur à un tel circuit mémoire « intelligent » ne sont malheureusement pas toujours présentes dans la mémoire intelligente. En outre, même si elles sont présentes dans la mémoire, elles ne sont pas forcément mémorisées dans un espace souhaité de la mémoire, ou selon un ordre de stockage idéal, ce qui peut nécessiter des opérations de manipulation de données dans la mémoire par des lectures/écritures orchestrées par le processeur. Ainsi, il est souhaitable de trouver des solutions pour décharger encore davantage l'utilisation du processeur et de façon générale les canaux d'échange de données utilisés par le processeur.

### Résumé de l'invention

Pour cela, un mode de réalisation prévoit un dispositif mémoire comportant :
- un port de connexion du dispositif à un processeur ;
- un circuit mémoire adapté à mettre en oeuvre des opérations de calcul et à réaliser des opérations élémentaires incluant une lecture, une écriture ou un calcul ;
- un premier circuit de contrôle adapté à recevoir des premières instructions en provenance du processeur via ledit port, et à décomposer chaque première instruction reçue en une séquence d'une ou de plusieurs opérations élémentaires de façon à générer un premier flux de requête d'opérations élémentaires ;
- un circuit de transfert direct de données depuis ou vers ledit circuit mémoire, le circuit de transfert direct étant adapté à recevoir des deuxièmes instructions en provenance du processeur via ledit port, à décomposer chaque deuxième instruction reçue en une séquence de plusieurs opérations élémentaires à réaliser dans ledit circuit mémoire de façon à générer un deuxième flux de requête d'opérations élémentaires ;
- une liaison interne d'échange de données reliant directement ledit circuit mémoire au circuit de transfert direct ; et
- un circuit d'arbitrage adapté à recevoir les premier et deuxième flux de requête d'opérations élémentaires et à commander le premier circuit de contrôle pour exécuter un unique flux global de requête d'opérations élémentaires dans le circuit mémoire mettant en oeuvre des règles de priorité prédéfinies dans le cas de requêtes simultanées d'accès au circuit mémoire,
dans lequel la liaison interne a une largeur de données supérieure à la largeur de données du port de connexion du dispositif au processeur.

Selon un mode de réalisation, le circuit de transfert direct comprend un circuit buffer adapté à stocker temporairement des données transitant depuis ou vers le circuit mémoire.

Selon un mode de réalisation, le dispositif comprend un circuit de distribution connecté audit port de connexion du dispositif au processeur, le circuit de distribution recevant les premières et deuxièmes instructions en provenance du processeur et étant adapté à transmettre les premières instructions au premier circuit de contrôle et les deuxièmes instructions au circuit de transfert direct, le circuit de distribution utilisant une information d'adresse présente dans l'instruction pour réaliser cette distribution.

Selon un mode de réalisation, la liaison interne a une largeur de données égale à la taille du plus grand vecteur de données pouvant être lu en une fois dans ledit circuit mémoire.

Selon un mode de réalisation, la liaison interne a une largeur de données au moins deux fois supérieure à la largeur de données du port de connexion du dispositif au processeur.

Selon un mode de réalisation, le circuit de transfert direct est connecté à un port de connexion du module à un bus système mémoire externe au dispositif.

Selon un mode de réalisation, le port de connexion du dispositif au bus système mémoire présente une largeur de données supérieure à la largeur de données du port de connexion du dispositif au processeur.

Selon un mode de réalisation, le circuit buffer du circuit de transfert direct est adapté à stocker temporairement des données transitant entre ledit circuit mémoire et un circuit mémoire externe relié audit bus système mémoire.

Selon un mode de réalisation, le circuit de transfert direct comprend des registres de configuration stockant les deuxièmes instructions reçues en provenance du processeur.

Selon un mode de réalisation, le circuit de transfert direct comprend en outre un deuxième circuit de contrôle adapté à lire et écrire dans les registres de configuration, à échanger des données de contrôle avec le circuit d'arbitrage, et à commander des transferts de données via le circuit buffer.

Selon un mode de réalisation, ledit circuit mémoire comprend une pluralité de circuits mémoire adaptés à mettre en oeuvre des opérations de calcul, lesdits circuits mémoire étant agencés en matrice selon des rangées et des colonnes.

Selon un mode de réalisation, la matrice de circuits mémoire est reconfigurable de façon à ajuster la dimension des vecteurs de données dans la direction des rangées.

Un mode de réalisation prévoit un système comportant un dispositif mémoire, un processeur adapté à transmettre les premières et deuxièmes instructions au dispositif mémoire, un bus système mémoire relié au circuit de transfert direct du dispositif mémoire, et un circuit mémoire externe relié au bus système mémoire, dans lequel le circuit de transfert direct est adapté à transférer des données directement entre le circuit mémoire du dispositif et le circuit mémoire externe via le bus système mémoire, sans passer par le processeur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de façon schématique un exemple d'un circuit mémoire adapté à mettre en oeuvre des opérations de calcul ;
la figure 2 représente de façon schématique un exemple d'un système comportant un module mémoire adapté à mettre en oeuvre des opérations de calcul et un circuit de transfert de données couplé audit module mémoire selon un mode de réalisation ;
la figure 3 illustre plus en détail un exemple d'implémentation du système de la figure 2 ;
la figure 4 représente un exemple de réalisation d'un circuit de transfert de données du module mémoire de la figure 3 ; et
la figure 5 illustre un autre exemple d'un système comportant un module mémoire adapté à mettre en oeuvre des opérations de calcul et un circuit de transfert de données couplé audit module mémoire selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des différents éléments des modules mémoire et des systèmes décrits n'a pas été détaillée, la réalisation de ces éléments étant à la portée de la personne du métier à partir des indications de la présente description. En particulier, la réalisation des circuits mémoire adaptés à mettre en oeuvre des opérations de calcul n'a pas été détaillée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

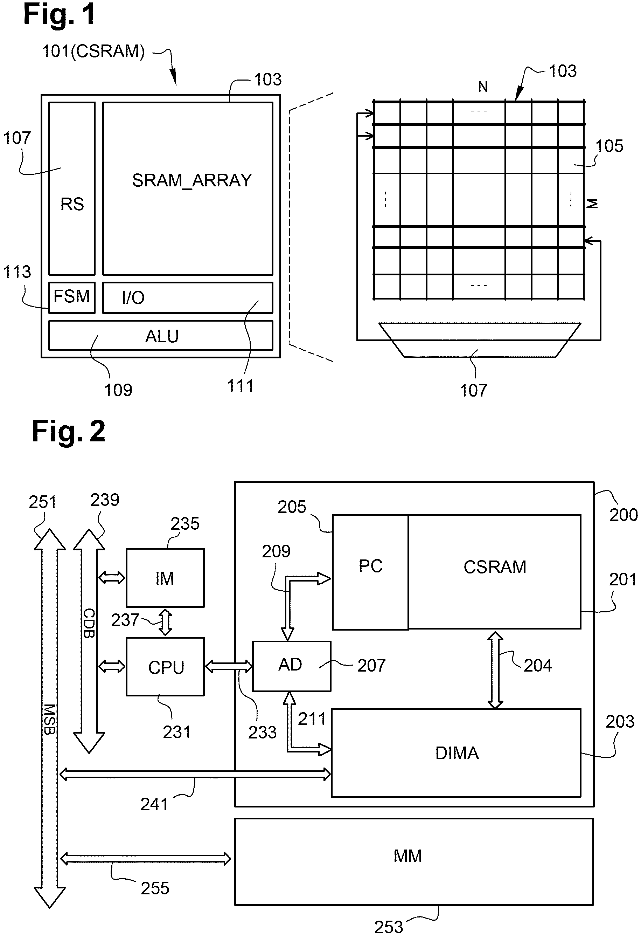

La figure 1 représente de façon schématique un exemple d'un circuit mémoire 101 (CSRAM) adapté à mettre en oeuvre des opérations de calcul. Le circuit 101 comprend une matrice 103 (SRAM_ARRAY) de cellules élémentaires de stockage, par exemple des cellules SRAM (de l'anglais "Static Random Access Memory" - mémoire statique à accès aléatoire). En partie droite de la figure, on a représenté plus en détail certains éléments du circuit mémoire 101, et en particulier la matrice 103 de cellules élémentaires de stockage. Dans cet exemple, la matrice 103 comprend M rangées et N colonnes de cellules élémentaires de stockage 105, avec M et N entiers supérieurs ou égaux à 2. A titre d'exemple, la matrice 103 est similaire aux matrices décrites dans la demande de brevet EP3252774 précédemment déposée par le demandeur.

Le circuit mémoire 101 comprend en outre un circuit de sélection de rangées 107 (RS) adapté à sélectionner une unique rangée de la matrice 103 pour réaliser une opération de lecture ou d'écriture classique. Le circuit de sélection de rangées 107 peut en outre être adapté à sélectionner simultanément en lecture plusieurs rangées de la matrice 103, de façon à mettre en oeuvre, sur des pistes conductrices de sortie de colonne de la matrice, des opérations logiques de base ayant pour opérandes des données stockées dans les rangées sélectionnées.

Le circuit mémoire 101 peut par ailleurs comprendre un circuit de calcul 109 (ALU) adapté à mettre en oeuvre des opérations de calcul supplémentaires à partir des signaux lus sur les pistes conductrices de sortie de colonne de la matrice 103 et/ou à réécrire directement dans la matrice 103 le résultat d'une opération de calcul, sans passer par des bornes de connexion externes du circuit mémoire 101.

Le circuit mémoire 101 comprend en outre un circuit d'entrée/sortie 111 (I/O) reliant les colonnes de la matrice à des bornes de connexion à l'extérieur du circuit mémoire, par exemple à un port d'entrée/sortie de données (non détaillé sur la figure 1) du circuit mémoire.

Le circuit mémoire de la figure 1 comprend en outre un circuit de contrôle 113 (FSM) relié aux circuits 107, 109 et 111. Le circuit 113 est adapté à décoder et à commander l'exécution d'instructions de lecture, d'écriture et/ou de calcul transmises par un circuit externe de contrôle (non représenté), par exemple un processeur.

La demande de brevet EP3503103 précédemment déposée par le demandeur décrit un exemple d'intégration d'un circuit mémoire adapté à mettre en oeuvre des opérations de calcul dans un système comprenant un processeur. Dans ce système, les accès en lecture et en écriture au circuit mémoire adapté à mettre en oeuvre des opérations de calcul sont effectués par l'intermédiaire du processeur. Ceci peut causer des ralentissements du système lorsque des quantités de données importantes sont transférées depuis ou vers le circuit mémoire adapté à mettre en oeuvre des opérations de calcul.

La figure 2 représente de façon schématique un exemple d'un système comportant un module mémoire 200 adapté à mettre en oeuvre des opérations de calcul selon un mode de réalisation.

Le module mémoire 200 de la figure 2 comprend un circuit mémoire 201 (CSRAM) adapté à mettre en oeuvre des opérations de calcul.

Le circuit mémoire 201 peut être un circuit mémoire de type IMC (de l'anglais "In Memory Computing" - calcul en mémoire), c'est-à-dire dans lequel des calculs sont mis en oeuvre directement au sein de la matrice de cellules élémentaires du circuit mémoire, par exemple tel que décrit en relation avec la figure 1 ou dans la demande de brevet EP3252774 susmentionnée. Plus généralement, le circuit mémoire 201 peut être tout circuit mémoire adapté à mettre en œuvre des opérations de calcul, par exemple un circuit de type NMC (de l'anglais "Near Memory Computing" - calcul à proximité de la mémoire), c'est-à-dire dans lequel les calculs ne sont pas réalisés directement au sein de la matrice de cellules élémentaires du circuit mémoire, mais dans des circuits de calcul intégrés en périphérie immédiate de la matrice de cellules élémentaires.

Le système de la figure 2 comprend un processeur 231 (CPU) . Plus généralement, le processeur 231 peut être remplacé par tout circuit adapté à générer un flux d'instructions de contrôle. Le système de la figure 2 comprend en outre une mémoire d'instructions 235 (IM) directement reliée au processeur 231 par l'intermédiaire d'une liaison 237. Le processeur 231 et la mémoire d'instructions 235 sont en outre reliés à un même bus système 239 (CDB), aussi appelé bus système processeur ou bus de données processeur ou bus de données CPU ("CPU data bus" en anglais). Le bus 239 peut être un bus du type classiquement utilisé pour échanger des données entre un processeur et des périphériques, par exemple des circuits mémoire, d'un système de traitement de données. Le bus 239 peut notamment comprendre un bus de données, un bus d'adresses et/ou un bus de contrôle. Le bus 239 peut être implémenté au moyen d'un système d'interconnexion distribué de type réseau sur puce ("network on chip" en anglais).

Selon un aspect d'un mode de réalisation, le module 200 comprend en outre un circuit 203 (DIMA) d'accès direct au circuit 201. Le circuit 203 est relié directement au circuit mémoire 201, par l'intermédiaire d'une liaison de transfert de données 204 interne au module 200. Le circuit 203 est en outre relié directement à un bus système de transfert de données 251 (MSB), aussi appelé bus système mémoire ("memory system bus" en anglais) externe au module 200, par l'intermédiaire d'une liaison 241. Dans cet exemple, le bus système mémoire 251 n'est pas directement connecté au processeur 231. Le bus 251 est un bus spécifiquement dédié au transfert direct (i.e. sans passer par le processeur 231) de données entre le circuit mémoire 201 du module 200 et d'autres circuits périphériques du système, par exemple une mémoire distante, ou toute autre mémoire interne ou externe susceptible d'échanger des données avec le circuit mémoire 201. Le bus 251 peut notamment comprendre un bus de données, un bus d'adresses et/ou un bus de contrôle. Le bus 251 peut être implémenté au moyen d'un système d'interconnexion distribué de type réseau sur puce ("network on chip" en anglais).

On notera que le bus mémoire système 251 et le bus système 239 peuvent avantageusement être reliés l'un à l'autre par différents circuits d'interface comme cela est connu de l'homme de l'art. En outre, le bus système 239 et le bus système mémoire 251 peuvent être un même et unique bus, même si cela n'est pas le mode de réalisation préférentiel. En effet, le bus système 239 est souvent de petite taille pour les données et mettre les deux bus en commun aurait sans doute pour conséquence d'avoir un bus 251 de petite taille, et de surcroît d'augmenter le débit nécessaire sur le bus commun ce qui pourrait en pratique se traduire par une saturation du bus, et par ricochet une diminution du débit d'échanges de données par rapport à une configuration à deux bus.

De préférence, le bus système mémoire 251 est plus large que le bus système processeur 239. La liaison de transfert de données 204 a de préférence une largeur égale à la taille du plus grand vecteur de données pouvant être lu en une fois dans le circuit mémoire 201, par exemple égale à la taille d'une rangée de circuits de lecture présents en pieds de colonnes dans la matrice de cellules élémentaires de stockage du circuit mémoire 201. Dans le cas où il n'y a pas de multiplexage en pied de colonne, la taille de ce plus grand vecteur de données peut être égale à N bits si l'on considère l'exemple de la figure 1. Dans le cas où il y a un multiplexage en pied de colonne, alors la taille de ce plus grand vecteur sera réduite du facteur de multiplexage par rapport à ce nombre N de bits présents sur une rangée. A titre de variante, la liaison 204 peut avoir une largeur égale à un sous-multiple de la taille du plus grand vecteur de données pouvant être lu en une fois dans le circuit mémoire 201. Le bus 251 peut avoir une largeur égale à la largeur de la liaison 204. A titre de variante, la largeur du bus 251 peut être un sous-multiple de la largeur de la liaison 204. La largeur de la liaison 204 est de préférence supérieure à la largeur d'un port d'entrée/sortie du processeur 231. On notera que par largeur d'un bus, d'un port ou d'une liaison, on entend ici la largeur des données pouvant transiter en parallèle sur le bus, le port ou la liaison (indépendamment d'éventuels signaux additionnels d'adresse et/ou de contrôle).

Le circuit d'accès direct 203 est adapté à transférer des données directement, c'est-à-dire sans faire transiter ces données par le processeur 231, entre le circuit mémoire 201 et le bus système mémoire 251. Dans l'exemple représenté, le système comprend en outre un circuit mémoire 253 (MM) externe au module 200. Le circuit mémoire 253 est relié au bus système mémoire 251 par l'intermédiaire d'une liaison 255. Ainsi, le circuit d'accès direct 203 permet de transférer des données directement, c'est-à-dire sans faire transiter ces données par le processeur 231, entre le circuit mémoire 201 du module 200 et le circuit mémoire externe 253. Plus généralement, le circuit d'accès direct 203 permet de transférer des données directement, c'est-à-dire sans faire transiter ces données par le processeur 231, entre le circuit mémoire 201 du module 200 et tout circuit périphérique connecté au bus système mémoire 251. A titre d'exemples non limitatif, le circuit mémoire 253 peut être une mémoire de type SRAM, une mémoire de type NVM (de l'anglais "Non Volatil Memory" - mémoire non volatile), une mémoire de type DRAM (de l'anglais "Dynamic Random Access Memory" - mémoire dynamique à accès aléatoire), une mémoire de type Flash, ou encore un autre circuit mémoire adapté à mettre en oeuvre des opérations de calcul. Les différents composants du module 200 peuvent être intégrés dans une même puce de circuits intégrés. Le circuit mémoire 253 peut être intégré à cette même puce, ou externe à cette puce.

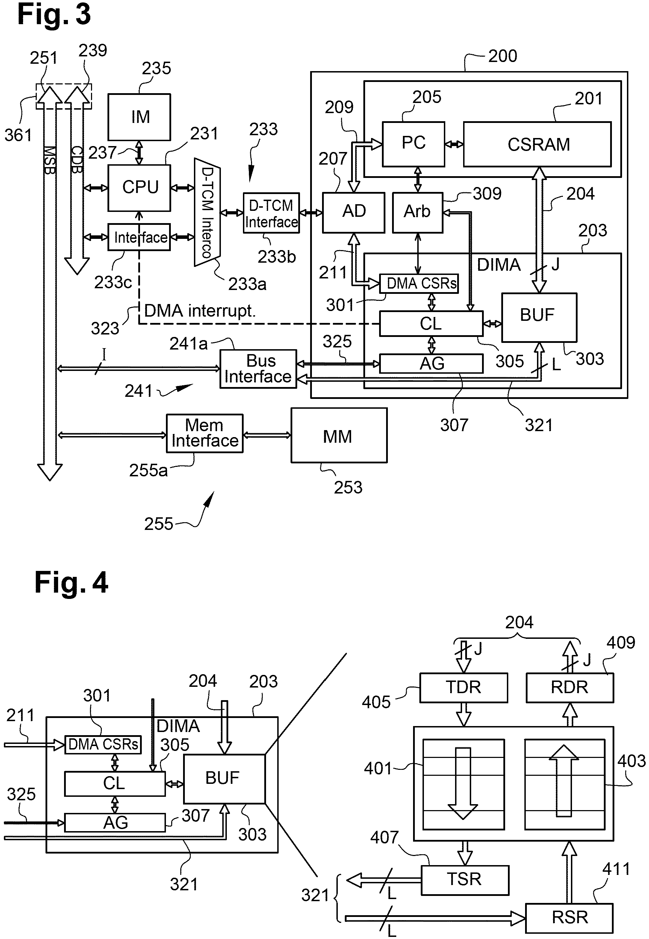

Dans l'exemple de la figure 2, le module 200 comprend en outre un circuit de contrôle 205 (PC pour Pipeline Controller) adapté à ordonnancer les accès au circuit mémoire 201 requis par le processeur 231. Le circuit 205 est adapté à décoder les instructions reçues en provenance du processeur 231 et à décomposer, si nécessaire, chaque instruction reçue en une séquence de plusieurs sous-opérations aussi appelées opérations élémentaires. Par opération élémentaire, on entend une opération de lecture, d'écriture ou de calcul dans la mémoire 201. Une opération de calcul peut éventuellement consister à actionner uniquement une unité de calcul accolée à la matrice mémoire (dans le cas par exemple d'une mémoire de type NMC). Une opération de calcul peut également consister à réaliser une opération de lecture d'une ou plusieurs rangées avec actionnement de moyens de calcul placés en pied de colonne (dans le cas par exemple d'une mémoire de type IMC). De façon générale, on peut considérer qu'une opération élémentaire peut être réalisée dans un cycle d'accès à la mémoire 201, comme cela est par exemple décrit dans la demande de brevet français N°20/08272 déposée le 4 août 2020 par le demandeur en relation avec les figures 4A, 4B.

Les instructions envoyées par le processeur peuvent être des instructions simples correspondant à une unique requête d'écriture ou de lecture dans la mémoire sans opérations de calcul, ou peuvent être des instructions complexes pouvant nécessiter en pratique l'exécution de plusieurs opérations élémentaires de lecture, écriture ou calcul. Ainsi, le circuit 205 va procéder à une décomposition d'une instruction reçue en une séquence de plusieurs opérations élémentaires uniquement quand il reçoit une instruction complexe (ou « smart instruction » en anglais).

Les instructions complexes sont, après décodage, transformées en un flux d'opérations élémentaires, ou autrement dit une séquence d'opérations élémentaires. Par exemple, si une instruction complexe correspond à l'opération ET entre deux opérandes et à la mise en mémoire du résultat, la séquence élémentaire correspondant à cette instruction complexe va par exemple correspondre à :
- dans le cas d'une mémoire NMC : 1/ lire première opérande, 2/ lire deuxième opérande, 3/ calcul de l'opération ET, 4/ écriture résultat ;
- dans le cas d'une mémoire IMC : 1/ lire opérandes 1 et 2 par multi sélection de lignes et configuration du circuit de lecture pour réaliser une opération ET lors de la lecture, 2/ écriture du résultat.

Dans le cas où la mémoire 201 peut, de par sa structure, réaliser plusieurs opérations élémentaires simultanément, il est alors possible de paralléliser certaines opérations élémentaires. Ainsi, il est possible de démarrer une séquence d'opérations correspondant à une n-ième instruction sans avoir terminé l'exécution d'une (n-1)-ième instruction. Autrement dit, des opérations élémentaires parallélisées peuvent correspondre à des instructions simples ou complexes différentes. Afin d'éviter des erreurs d'exécution de la séquence d'instructions reçues liées à cette possibilité de parallélisation, le circuit 205 peut dans ce cas inclure un dispositif d'analyse des séquences d'opérations correspondant aux instructions successives, pour insérer si besoin un ou des cycles d'attente dans une séquence d'opérations élémentaires correspondant à une instruction, lorsqu'un conflit potentiel est détecté.

Le module 200 de la figure 2 comprend en outre un circuit 207 (AD) de distribution des requêtes en provenance du processeur 231. Le circuit 207 est relié au processeur 231 par l'intermédiaire d'une liaison 233. Le circuit 207 est en outre relié au circuit de contrôle 205 du circuit mémoire 201 par une liaison 209 interne au module 200, et au circuit d'accès direct 203 par une liaison 211 interne au module 200. Le circuit 207 permet de contrôler la distribution du flux d'instructions en provenance du processeur 231 entre d'une part le circuit mémoire 201 (via la liaison 209 et le circuit de contrôle 205) et d'autre part le circuit d'accès direct 203 (via la liaison 211). Un mécanisme de type mappage mémoire peut être prévu pour réaliser le routage (aiguillage) des instructions vers l'un ou l'autre du circuit mémoire 201 et du circuit d'accès direct 203, en fonction d'un champ d'adresse contenu dans l'instruction. De façon connue en soi, ce mécanisme de mappage mémoire vise à réaliser une association entre une adresse vue/connue du processeur et une adresse compréhensible par le matériel, ici la mémoire 201 ou le circuit d'accès direct 203.

Le processeur 231 peut requérir des accès en lecture ou en écriture au circuit mémoire 201, ou encore l'exécution de calculs par le circuit mémoire 201. Le processeur peut en outre requérir des transferts directs (via le circuit 203) de données entre le circuit mémoire 201 et un circuit périphérique externe au module 200, par exemple le circuit mémoire 253. Ces requêtes sont réparties entre le circuit de contrôle 205 et le circuit d'accès direct 203 par le circuit de distribution 207.

Dans le système de la figure 2, le module 200 est relié ou connecté au processeur par une liaison ou port de connexion 233. La largeur du port de connexion 233 est inférieure à la largeur de la liaison interne 204 du module 200. A titre d'exemple, la largeur du port de connexion 233 est au moins deux fois plus petite et de préférence au moins quatre fois plus petite que la largeur de la liaison interne 204. A titre d'exemple, la largeur de la liaison 233 est égale à 32 bits.

La largeur relativement grande de la liaison interne 204 permet in fine de transférer, via le circuit de transfert direct 203, des volumes de données plus importants par rapport au cas où le bus de donnée 204 est de même taille, pour les données, que celle du port de connexion 233. En effet, pour un accès en mémoire demandé par le circuit de transfert direct 203, il est possible d'écrire/lire en parallèle plus de données en passant par la liaison interne 204 qu'en passant par le port de connexion 233 en provenance/à destination du CPU 231.

On notera que l'utilisation d'un circuit de transfert direct 203 associé à une mémoire 201 permettant de faire du calcul, notamment du calcul de type SIMD de l'anglais « Single Instruction Multiple Data », permet d'avoir en très grande majorité des écritures/lectures de données vers/depuis la mémoire qui passent par le circuit de transfert direct 203. Les échanges entre le CPU et la mémoire 201 sont alors majoritairement des transferts « d'instructions » visant à lancer des opérations de calcul (SIMD) et très peu des transferts classiques consistant à réaliser une simple lecture ou écriture de données en mémoire (sans lancer d'opérations de calcul).

La figure 3 illustre plus en détail un exemple d'implémentation du système de la figure 2.

Le système de la figure 3 comprend les mêmes éléments que dans l'exemple de la figure 2, agencés sensiblement de la même manière.

Dans l'exemple de la figure 3, on a représenté plus en détail différents éléments du circuit d'accès direct 203 du module 200.

Plus particulièrement, dans cet exemple, le circuit 203 comprend un ensemble 301 (DMA CSRs) de registres d'état aussi appelés registres de configuration recevant les instructions en provenance du processeur 231, par l'intermédiaire de la liaison 211. Les registres 301 stockent les instructions de transfert à exécuter par le circuit 203. A titre d'exemple, les registres 301 stockent les plages d'adresses source et destination des transferts à réaliser. Les registres 301 peuvent en outre stocker la taille des blocs de données à transférer. Les instructions de transfert stockées dans les registres 301 peuvent en outre comprendre des instructions spécifiques au circuit d'accès direct 203 de réarrangement des données à l'intérieur du circuit d'accès direct 203, de manière à permettre de modifier l'arrangement des données lors de leur transfert entre la source et la destination.

Le circuit 203 comprend en outre un circuit buffer 303 (BUF) relié au circuit mémoire 201 par l'intermédiaire de la liaison interne 204, et au bus système mémoire 251 par l'intermédiaire d'une liaison de transfert de données 321. Le circuit buffer 303 stocke temporairement les données transitant du circuit mémoire 201 vers le bus système mémoire 251, ou du bus système mémoire 251 vers le circuit mémoire 201.

Le circuit 203 comprend de plus un circuit logique de contrôle 305 (CL). Le circuit logique de contrôle 305 est relié d'une part aux registres d'état 301 et d'autre part au circuit buffer 303. Le circuit 305 est adapté à commander des transferts de données éventuellement à l'intérieur du circuit buffer 303, mais surtout entre le circuit buffer 303 et les liaisons 204 et 321, en fonction de l'état de l'exécution d'une instruction préalablement stockée dans les registres 301. Lorsque l'exécution d'une instruction de transfert de données requise par le processeur 231 est terminée, le circuit logique de contrôle 305 renvoie une interruption au processeur 231 pour l'en informer. L'interruption peut être transmise par une liaison 323 (DMA interrupt) connectant le circuit 305 au processeur 231.

Le circuit 203 comprend en outre un circuit de génération d'adresses 307 (AG). Le circuit 307 est relié au circuit logique de contrôle 305. Le circuit 307 est en outre relié au bus système mémoire 251 par l'intermédiaire d'une liaison de transfert de signaux d'adresse 325. Le circuit de génération d'adresses 307 est adapté à générer une séquence de signaux d'adresse pour transférer successivement les données entre le circuit buffer 303 et le bus 251, conformément aux instructions stockées dans les registres 301.

Dans l'exemple représenté en figure 3, la liaison 241 reliant le circuit d'accès direct 203 au bus système mémoire 251 comprend un circuit d'interface de bus 241a (Bus Interface). Le circuit 241a est par exemple un circuit d'interface de bus maitre. Le circuit 241a comprend un premier port relié, par exemple connecté, au bus 251, et un deuxième port relié, par exemple connecté, respectivement à un port d'entrée/sortie de données du circuit buffer 303 (via la liaison 321) et à un port d'entrée/sortie de signaux d'adresse du générateur d'adresses 307 (via la liaison 325).

Dans l'exemple de la figure 3, la liaison 255 reliant le bus système mémoire 251 au circuit mémoire externe 253 comprend un circuit d'interface de bus 255a (Mem Interface). Le circuit 255a est par exemple un circuit d'interface de bus esclave. Le circuit 255a comprend un premier port d'entrée/sortie relié, par exemple connecté, au bus 251, et un deuxième port d'entrée/sortie relié, par exemple connecté, à un port d'entrée/sortie du circuit mémoire 253.

Par ailleurs, dans l'exemple de la figure 3, la liaison 233 reliant le processeur 231 au circuit 207 de distribution des accès comprend un multiplexeur 233a (D-TCM interco) et un circuit d'interface 233b (D-TCM interface). Le circuit d'interface 233b est par exemple un circuit d'interface esclave. Le multiplexeur 233a comprend un premier port d'entrée/sortie relié, par exemple connecté, à un port d'entrée/sortie du processeur 231. Le multiplexeur 233a comprend en outre un deuxième port d'entrée/sortie relié directement (i.e. sans passer par le processeur 231) au bus système processeur 239 du système. Dans l'exemple représenté, un circuit d'interface de bus 233c (Interface), par exemple un circuit d'interface esclave, fait interface entre le bus système processeur 239 et le deuxième port d'entrée/sortie du multiplexeur 233a. Le circuit d'interface 233c comprend un premier port d'entrée/sortie relié, par exemple connecté, au bus 239, et un deuxième port d'entrée/sortie relié, par exemple connecté, au deuxième port d'entrée/sortie du multiplexeur 233a. Le multiplexeur 233a comprend en outre un troisième port d'entrée/sortie relié, par exemple connecté, à un premier port d'entrée/sortie du circuit d'interface 233b. Le circuit d'interface 233b a quant à lui un deuxième port d'entrée/sortie relié, par exemple connecté, à un port d'entrée/sortie du circuit 207. En fonctionnement, le multiplexeur est adapté à connecter alternativement l'un ou l'autre de ses premier et deuxième ports d'entrée/sortie à son troisième port d'entrée/sortie, de façon à relier le port d'entrée/sortie du circuit de répartition des accès 207 soit au processeur 231 soit directement au bus système processeur 239.

Dans l'exemple de la figure 3, le module 200 comprend en outre un circuit d'arbitrage 309 relié, par exemple connecté, d'une part au circuit de contrôle 205 du circuit mémoire 201, et d'autre part au circuit de contrôle 305 du circuit d'accès direct 203. Le circuit d'arbitrage 309 peut en outre être relié, par exemple connecté, aux registres de configuration 301 du circuit d'accès direct 203. Le circuit 309 est adapté à gérer l'exécution des instructions réalisées in fine par le circuit mémoire 201 de manière à arbitrer entre des demandes d'accès potentiellement simultanées provenant du processeur 231 ou du circuit d'accès direct 203. Plus particulièrement, alors que le circuit 207 a pour fonction de distribuer les instructions reçues du processeur 231 respectivement au circuit de contrôle 205 du circuit mémoire 201 du module 200 et aux registres de configuration 301 du circuit d'accès direct 203 du module 200, le circuit d'arbitrage 309 (Arb) gère les conflits éventuels entre des demandes de réalisation des opérations élémentaires dans le circuit mémoire 201 lors de l'exécution des instructions demandées par le processeur soit directement au circuit mémoire soit au circuit d'accès direct 203. Plus spécifiquement, chaque instruction est décomposée en une séquence d'opérations élémentaires par le circuit de contrôle 205 ou par le circuit de contrôle 305. Autrement dit, le circuit d'arbitrage 309 réalise un arbitrage entre deux flux parallèles distincts de requêtes d'opérations élémentaires, à savoir :
- un premier flux correspondant aux instructions envoyées par le processeur 231 au circuit mémoire 201, généré par le circuit de contrôle 205 ; et
- un deuxième flux correspondant à l'exécution des transferts de données entre le circuit mémoire 201 et la mémoire externe 253, généré par le circuit de contrôle 305.

Les requêtes reçues par le circuit d'arbitrage 309 en provenance du circuit de contrôle 205 et du circuit de contrôle 305 sont autorisées ou retardées par le circuit d'arbitrage en fonction des conflits potentiels de demandes d'accès au circuit mémoire 201. Autrement dit, le circuit d'arbitrage 309 transmet au circuit de contrôle 205 du circuit mémoire 201 un unique flux de requête d'opérations élémentaires, appelé flux global, correspondant à une combinaison entrelacée des premier et deuxième flux, selon un ordonnancement défini par des règles de priorité prédéfinies. La granularité de l'entrelacement des premier et deuxième flux peut être à l'échelle des opérations élémentaires, ou à une échelle plus haut niveau, c'est-à-dire à une échelle de groupes d'opérations élémentaires.

Les instructions envoyées par le processeur 231 au circuit de contrôle 205 ou écrites dans les registres de configuration 301 peuvent comporter des bits de priorité exploités in fine par le circuit d'arbitrage 309 pour décider de l'ordre de traitement des opérations élémentaires. Ainsi, selon un mode de réalisation, les premier et deuxième flux de requête d'opérations élémentaires reçus par le circuit d'arbitrage 309 peuvent chacun inclure un ou des bits de priorité indiquant la priorité correspondante de chaque opération élémentaire en fonction de la priorité indiquée par le processeur lors de l'envoi de l'instruction correspondante. Dans le cas par exemple où le circuit d'arbitrage 309 reçoit simultanément des requêtes d'opérations élémentaires pour chacun des premier et deuxième flux, alors une règle par défaut peut être donnée pour leur traitement. On peut par exemple donner toujours priorité au premier flux, ou donner priorité à tour de rôle entre les deux flux.

La liaison 204 reliant le circuit mémoire 201 au circuit d'accès direct 203, permettant de réaliser des transferts directs (sans passer par le processeur 231) de données entre le circuit mémoire 201 et la mémoire distante 253 est par exemple adaptée à transmettre uniquement des signaux de données correspondant aux données lues ou à écrire dans le circuit mémoire 201 et correspondant respectivement à des données écrites ou lues dans le circuit buffer 303.

La largeur des données pouvant être transmises simultanément via la liaison 204 est par exemple égale ou supérieure à la largeur du bus système mémoire 251. Les modes de réalisation décrits ne se limitent toutefois pas à ce cas particulier.

Pour chaque requête d'opération élémentaire du deuxième flux, des signaux d'adresse et de contrôle utilisés pour indiquer l'adresse de chaque donnée à transférer, le type d'accès à réaliser (lecture ou écriture), la taille de la donnée à transférer, etc., peuvent être transmis par le circuit 305 au circuit de contrôle 205 du circuit mémoire 201, via le circuit d'arbitrage ou éventuellement directement. Quel que soit le mode de réalisation, il est nécessaire de prévoir un mécanisme de synchronisation entre le circuit d'arbitrage, le circuit de contrôle 205 et le circuit de transfert direct afin d'assurer que les signaux d'adresse et de contrôle correspondant à une requête d'opération élémentaire émise par le circuit logique 305 soient pris en compte par le circuit mémoire pour l'exécution de l'opération élémentaire en même temps que les données à écrire ou lire dans le circuit buffer 303 transitent sur la liaison 204 pour cette même opération élémentaire. Ainsi, par exemple, on peut prévoir qu'une requête d'opération élémentaire transmise au circuit d'arbitrage par le circuit logique 305 inclut toutes les informations d'adresse et de contrôle et que le circuit d'arbitrage envoie au circuit logique 305 une information, type requête d'acquittement, pour lui signifier qu'il lance l'exécution de l'opération élémentaire dans le circuit mémoire 201, et par suite que le circuit de transfert de données peut envoyer une donnée sur la liaison 204 (dans le cas d'une écriture dans le circuit mémoire 201) ou récupérer une donnée sur la liaison 204 (dans le cas d'une lecture dans le circuit mémoire 201). D'autres mécanismes de synchronisation entre le circuit d'arbitrage 309, le circuit mémoire 201 et le circuit de transfert direct 203 peuvent bien entendu être mis en place.

En outre, le circuit d'arbitrage a été représenté précédemment comme un circuit différent du circuit de contrôle 205 du circuit mémoire 201 afin principalement de mettre en avant la fonction, le rôle, d'arbitrage indispensable à la mise en œuvre d'un circuit selon la présente invention dans lequel deux flux de requête d'opérations élémentaires souhaitent accéder à une même ressource, à savoir la matrice 103 et les moyens de calcul en mémoire (par exemple 107). Cette fonction d'arbitrage pourrait par exemple être réalisée par le circuit de contrôle 205 du circuit mémoire 201. Le circuit de contrôle 205 dialoguerait ainsi directement avec le circuit logique 305 et plus généralement le circuit de transfert direct 203 ; le circuit de contrôle 205 recevrait ainsi, via deux ports d'entrée/sortie, des requêtes d'instructions du processeur 231 et des requêtes d'instructions du circuit 203 sous forme de requêtes d'opérations élémentaires, ou sous forme éventuellement d'instructions plus haut niveau à décoder par le circuit 205 en utilisant par exemple le même décodeur que celui utilisé pour décoder les instructions provenant du processeur 231. Selon un autre mode de réalisation, le circuit décodeur d'instructions présent dans le circuit de contrôle 205 est « déporté » dans le circuit d'arbitrage 309 et le circuit de contrôle 205 traite et reçoit un unique flux global de requête d'opérations envoyé par le circuit d'arbitrage 309.

La figure 4 représente plus en détail un exemple de réalisation du circuit de transfert direct de données 203 du module mémoire 200 de la figure 3.

Plus particulièrement, sur la figure 4, on a représenté plus en détail (en partie droite de la figure) un exemple de réalisation du circuit buffer 303 du circuit 203.

Dans cet exemple, le circuit buffer 303 comprend deux sous-circuits de transfert unidirectionnel 401 et 403 de type FIFO (de l'anglais "First In First Out" - premier entré premier sorti). Le circuit 401 est adapté à transmettre des données du circuit mémoire 201 du module 200 vers le bus système mémoire 251. Le circuit 403 est quant à lui adapté à transmettre des données du bus système mémoire 251 vers le circuit mémoire 201. Le circuit 401 comprend un port d'entrée relié à un port de sortie du circuit mémoire 201 (non visible sur la figure 4), via la liaison interne 204. Dans cet exemple, un registre de transmission de données 405 (TDR) fait interface entre la liaison 204 et le port d'entrée du circuit 401. Le circuit 401 comprend en outre un port de sortie relié au bus système mémoire 251, via la liaison 321. Dans cet exemple, un registre de transmission de données 407 (TSR) fait interface entre le port de sortie du circuit 401 et la liaison 321. Le circuit 403 comprend un port de sortie relié à un port d'entrée du circuit mémoire 201, via la liaison interne 204. Dans cet exemple, un registre de transmission de donnée 409 (RDR) fait interface entre le port de sortie du circuit 403 et la liaison 204. Le circuit 403 comprend en outre un port d'entrée relié au bus système mémoire 251, via la liaison 321. Dans cet exemple, un registre de transmission de données 411 (RSR) fait interface entre la liaison 321 et le port d'entrée du circuit 403.

Les circuits 401 et 403 permettent de stocker temporairement les données pendant leur transfert du circuit mémoire 201 vers le bus système mémoire 251 ou du bus système mémoire 251 vers le circuit mémoire 201. Plus généralement, tout autre agencement du circuit buffer 303 adapté à remplir cette fonction peut être prévu.

Le circuit buffer 303 peut en outre avoir une fonction d'adaptation de la taille des données entre la liaison 204 et la liaison 321. A titre d'exemple, la liaison 204 peut avoir une largeur de données J, la liaison 321 peut avoir une largeur de données L, et le bus système mémoire 251 peut avoir une largeur de données I, avec J, L et I entiers supérieurs à 1. La largeur J peut être égale à la largeur L. A titre de variante, la largeur J peut être différente de la largeur L. Dans ce cas, le circuit buffer 303 est configuré pour adapter la taille des données transmises. Par exemple, la largeur J peut être supérieure à la largeur L. L'adaptation de la taille des données peut être réalisée par les registres 405, 407, 409 et 411. A titre d'exemple, les registres 409 et 411 peuvent être des registres à décalage. Par ailleurs, la largeur I peut être égale à la largeur L, ou différente de la largeur L. A titre d'exemple, la largeur I est inférieure à la largeur L. L'adaptation de taille des données (sérialisation) entre la liaison 321 et le bus système mémoire 251 peut être réalisée par le circuit d'interface 241a.

A titre d'exemple, non limitatif, la largeur J est égale à 2048 bits, la largeur L est égale à 512 bits, et la largeur I est égale à 128 bits.

La largeur des mots des buffers 401 et 403 est par exemple égale à la largeur J, ou à la largeur L.

A titre d'exemple, lors d'une transmission de données du bus système mémoire 251 vers le circuit mémoire 201, le buffer 403 est rempli successivement par sous-mots de largeur L jusqu'à ce qu'un mot complet de largeur J soit disponible pour être transmis au circuit mémoire 201 via la liaison 204. Lors d'une transmission de données du circuit mémoire 201 vers le bus système mémoire 251, le buffer 401 est lu par sous-mots de largeur L, transmis successivement au bus système mémoire 251 via la liaison 321.

Du point de vue de la programmation, le circuit d'accès direct 203 du module 200 est contrôlé par le processeur 231 par l'intermédiaire des registres d'état 301. Des instructions dédiées sont utilisées pour contrôler les transferts de données via le circuit 203.

Les accès en écriture au circuit mémoire 201 du module 200, par exemple pour transférer des données depuis la mémoire externe 253 vers le circuit mémoire 201, via le circuit d'interface 241a et le circuit d'accès direct 203, peuvent être mis en oeuvre comme suit. D'abord, le processeur 231 écrit une instruction complète de transfert dans les registres de configuration 301 du circuit 203 via le circuit d'interface 233b et le circuit 207 de distribution des instructions du module 200. L'instruction comprend notamment l'adresse source des données à transférer (c'est-à-dire l'adresse des données dans la mémoire externe 253), la taille du bloc de données à transférer, l'adresse destination des données à transférer (c'est-à-dire l'adresse des données dans le circuit mémoire 201), et éventuellement une consigne de réagencement des données lors du transfert. Le circuit logique de contrôle 305 du circuit 203 génère ensuite une requête d'accès en lecture à la mémoire 253 à l'adresse source spécifiée (fournie par le générateur d'adresses 307). Cette requête est envoyée par le circuit d'interface 241a du module 200 au circuit d'interface 255a du circuit mémoire externe 253, via le bus système mémoire 251. Lorsque les données source sont prêtes, la mémoire externe 253 envoie l'ensemble des données requises, par exemple en salve continue, directement dans le circuit buffer 303 du circuit 203, via les circuits d'interface 255a et 241a et le bus système mémoire 251. Les données sont ensuite transférées du circuit buffer 303 vers le circuit mémoire 201, par l'intermédiaire de la liaison interne 204 du module 200, lorsque le circuit d'arbitrage 309 autorise ce transfert. Ce transfert peut être un transfert continu au fur et à mesure que les données sont rendues disponibles en sortie du circuit buffer 303. A titre de variante, on peut attendre que la totalité des données soit disponible dans le circuit buffer 303 pour réaliser le transfert vers le circuit mémoire 201. Le choix du mode de transfert peut être effectué en fonction d'une éventuelle différence de fréquence de fonctionnement entre la mémoire externe 253 et le circuit mémoire 201 du module 200. Lors du transfert, les adresses destination sont communiquées au circuit de contrôle 205 du circuit mémoire 201 par le circuit d'arbitrage 309. Lorsque l'exécution de l'instruction de transfert est terminée, une interruption est renvoyée par le circuit de contrôle 305 à destination du processeur.

Les accès en lecture au circuit mémoire 201 du module 200, par exemple pour transférer des données depuis le circuit mémoire 201 vers la mémoire externe 253, via le circuit d'accès direct 203 du module 200 et le circuit d'interface 241a, peuvent être réalisés selon un chemin inverse à ce qui vient d'être décrit. Le processeur 231 écrit d'abord l'instruction complète dans les registres de configuration 301 du circuit 203, via le circuit d'interface 233b et le circuit 207 de distribution des instructions du module 200. Le circuit logique de contrôle 305 du circuit 203 génère ensuite une requête d'accès en lecture au circuit mémoire 201 à l'adresse source spécifiée. Cette requête est transmise au circuit mémoire 201 par l'intermédiaire du circuit d'arbitrage 309 et du circuit de contrôle 205. Les données sont alors transférées du circuit mémoire 201 vers le circuit buffer 303 via la liaison 204. Le contenu du circuit buffer 303 est ensuite transféré à l'adresse destination de la mémoire externe 253, via la liaison 321, le circuit d'interface 241a, le bus système mémoire 251, et le circuit d'interface 255a.

Dans le système de la figure 3, des accès aux données du circuit mémoire 201 du module 200 peuvent aussi être réalisés directement par le processeur 231 ou le bus système processeur 239, via la liaison 233 et en particulier via le circuit d'interface 233b. Par exemple, des données peuvent être transférées de la mémoire externe 253 vers le circuit mémoire 201 du module 200 en passant, dans l'ordre, par : le bus système mémoire 251, un circuit d'interconnexion système 361 reliant le bus 251 au bus système processeur 239 du processeur, le bus système processeur 239, le circuit d'interface 233c, le circuit d'interface 233b, le circuit de distribution 207, et le circuit de contrôle 205. Pour transférer des données du circuit mémoire 201 vers la mémoire externe 253, le chemin inverse peut être utilisé. De tels transferts peuvent toutefois être relativement longs et bloquer l'accès au processeur pendant une période de temps importante. Un avantage du circuit d'accès direct 203 est de permettre des transferts directs de données depuis ou vers le circuit mémoire 200, sans bloquer l'accès au processeur.

On a décrit ci-dessus des exemples d'implémentation dans lesquels le module 200 comprend un unique circuit mémoire 201 adapté à mettre en oeuvre des opérations de calcul.

A titre de variante, l'ensemble comprenant le circuit de contrôle 205 et le circuit 201 peut être remplacé par un module comprenant une pluralité de blocs élémentaires comprenant chacun un circuit mémoire adapté à mettre en oeuvre des opérations de calcul, par exemple du type décrit dans la demande de brevet français N°20/08272 susmentionnée, ou encore dans l'article intitulé "Reconfigurable Tiles of Computing-In-Memory SRAM Architecture for Scalable Vectorization" de R. Gauchi et al. (Proceedings of the ACM/IEEE International Symposium on Low Power Electronics and Design - Août 2020).

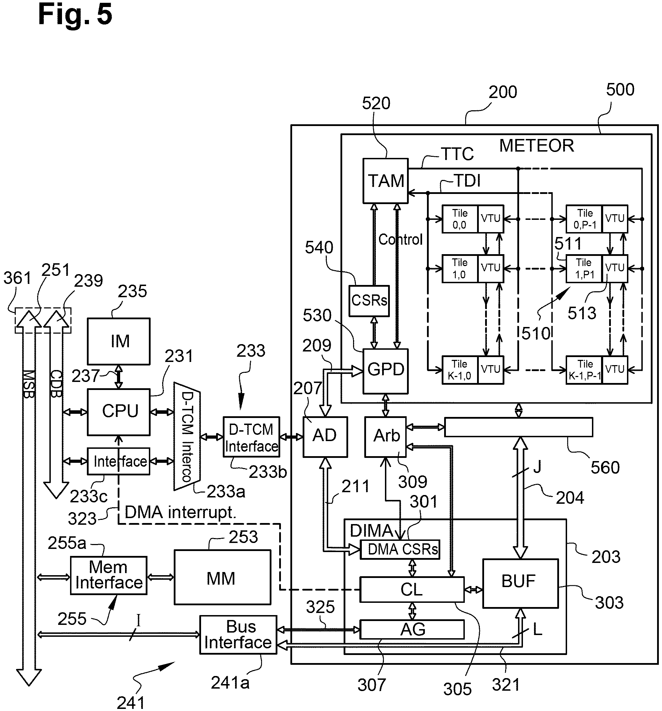

La figure 5 illustre un exemple d'un système comportant un module mémoire adapté à mettre en oeuvre des opérations de calcul selon un autre mode de réalisation.

Le système de la figure 5 est similaire au système de la figure 3 et diffère du système de la figure 3 essentiellement en ce que, dans le système de la figure 5, l'ensemble comprenant le circuit de contrôle 205 et le circuit 201 a été remplacé par un module 500 (METEOR).

Le module 500 est un module reconfigurable comprenant une pluralité de blocs élémentaires 510 agencés en matrice selon K rangées et P colonnes, avec P entier supérieur ou égal à 1, de préférence supérieur ou égal à 2, par exemple supérieur ou égal à 3, et K entier supérieur ou égal à 1, de préférence supérieur ou égal à 3.

Chaque bloc élémentaire 510 comprend un circuit mémoire 511, également référencé "Tile i,j", avec i entier allant de 0 à K-1 (Tile 0,0 ; Tile 1,0 ; Tile K-1,0) et j entier allant de 0 à P-1 (Tile 0,P-1 ; Tile 1,P-1 ; Tile K-1,P-1) désignant respectivement la position de la rangée et la position de la colonne du bloc élémentaire dans la matrice. Chaque circuit mémoire 511 est adapté à mettre en oeuvre des fonctions de calcul. Plus particulièrement, chaque circuit mémoire 511 est adapté à charger et stocker des données, et à mettre en oeuvre un certain nombre d'opérations logiques et/ou arithmétiques ayant pour opérandes les données stockées dans le circuit mémoire 511. Chaque circuit mémoire 511 est par exemple identique ou similaire au circuit mémoire 201 de la figure 3. Chaque bloc élémentaire 510 comprend en outre un circuit de transfert vertical 513, également référencé VTU, couplé au circuit mémoire 511 du bloc.

Dans chaque colonne de la matrice, les circuits de transfert configurables 513 de deux blocs élémentaires 510 adjacents quelconques de la colonne sont reliés deux à deux par un bus de liaison montant VTI-U et par un bus de liaison descendant VTI-D. Autrement dit, dans chaque colonne de la matrice, dans chaque bloc élémentaire 510 de rang i de la colonne à l'exception des blocs élémentaires des première (i=0) et dernière (i=K-1) rangées de la matrice, le circuit de transfert vertical 513 du bloc est relié, par exemple connecté, au circuit de transfert vertical 513 du bloc élémentaire 510 de rang i-1 par un bus de liaison montant VTI-U et par un bus de liaison descendant VTI-D, et est relié, par exemple connecté, au circuit de transfert vertical 513 du bloc élémentaire 510 de rang i+1 par un autre bus de liaison montant VTI-U et par un autre bus de liaison descendant VTI-D.

Dans chaque colonne, le circuit de transfert vertical 513 du bloc élémentaire 510 de rang i=0 est relié, par exemple connecté, au circuit de transfert vertical 513 du bloc élémentaire 510 de rang i=1 par un bus de liaison montant VTI-U et par un bus de liaison descendant VTI-D. De plus, dans chaque colonne, le circuit de transfert vertical 513 du bloc élémentaire 510 de rang i=K-1 est relié, par exemple connecté, au circuit de transfert vertical 513 du bloc élémentaire 510 de rang i=K-2 par un bus de liaison montant VTI-U et par un bus de liaison descendant VTI-D.

Dans cet exemple, dans chaque colonne de la matrice, dans chaque bloc élémentaire 510 de rang i de la colonne, à l'exception des blocs élémentaires 510 des première (i=0) et dernière (i=K-1) rangées de la matrice, le circuit de transfert vertical 513 du bloc est configurable pour :
a) transmettre sur un bus d'écriture de données (non détaillés sur la figure 1) du circuit mémoire 511 du bloc l'un ou l'autre de :
   - un mot de données reçu sur le bus de liaison descendant VTI-D reliant le circuit de transfert vertical 513 du bloc élémentaire 510 au circuit de transfert vertical 513 du bloc élémentaire 510 adjacent de rang i-1 dans la colonne ; et
   - un mot de données reçu sur le bus de liaison montant VTI-U reliant le circuit de transfert vertical 513 du bloc élémentaire 510 au circuit de transfert vertical 513 du bloc élémentaire 510 adjacent de rang i+1 dans la colonne ;
b) transmettre sur le bus de liaison montant VTI-U reliant le circuit de transfert vertical 513 du bloc élémentaire 510 au circuit de transfert vertical 513 du bloc élémentaire 510 adjacent de rang i-1 dans la colonne l'un ou l'autre de :
   - un mot de données reçu sur un bus de lecture de données (non détaillé sur la figure 1) du circuit mémoire 511 du bloc élémentaire ; et
   - un mot de données reçu sur le bus de liaison montant VTI-U reliant le circuit de transfert vertical 513 du bloc élémentaire 510 au circuit de transfert vertical 513 du bloc élémentaire 510 adjacent de rang i+1 dans la colonne ; et
c) transmettre sur le bus de liaison descendant VTI-D reliant le circuit de transfert vertical 513 du bloc élémentaire 510 au circuit de transfert vertical 513 du bloc élémentaire adjacent de rang i + 1 dans la colonne l'un ou l'autre de :
   - un mot de données reçu sur le bus de lecture de données du circuit mémoire 511 du bloc élémentaire ; et
   - un mot de données reçu sur le bus de liaison descendant VTI-D reliant le circuit de transfert vertical 513 du bloc élémentaire 510 au circuit de transfert vertical 513 du bloc élémentaire 510 adjacent de rang i-1 dans la colonne.

Dans chaque colonne, le circuit de transfert vertical 513 du bloc élémentaire 510 de rang i=0 est par exemple adapté à :
- transmettre un mot de données reçu sur le bus de lecture de données du circuit mémoire 511 du bloc 510 vers le bus de liaison descendant VTI-D reliant le bloc 510 au circuit de transfert vertical 513 du bloc élémentaire 510 adjacent de rang i=1 ; et/ou
- transmettre sur le bus d'écriture de données du circuit mémoire 511 du bloc 510 un mot de données reçu sur le bus de liaison montant VTI-U reliant le bloc 510 au circuit de transfert vertical 513 du bloc élémentaire 510 adjacent de rang i=1.

Dans chaque colonne, le circuit de transfert vertical 513 du bloc élémentaire 510 de rang i=K-1 est par exemple adapté à :
- transmettre un mot de données reçu sur le bus de lecture de données du circuit mémoire 511 du bloc 510 vers le bus de liaison montant VTI-U reliant le bloc 510 au circuit de transfert vertical 513 du bloc élémentaire 510 adjacent de rang i=K-2 ; et/ou
- transmettre sur le bus d'écriture de données du circuit mémoire 511 du bloc 510 un mot de données reçu sur le bus de liaison descendant VTI-D reliant le bloc 510 au circuit de transfert vertical 513 du bloc élémentaire 110 adjacent de rang i=K-2.

Le module mémoire 500 de la figure 5 comprend en outre un circuit interne 520 (TAM) de contrôle des blocs élémentaires 510. Le circuit 520 est notamment adapté à contrôler la configuration des circuits de transfert vertical 513 des blocs élémentaires 510 du module mémoire. Pour cela, un bus de contrôle TTC interne au module 500 relie le circuit 520 à des ports d'entrée de contrôle (non détaillés sur la figure) des circuits de transfert vertical 513 des différents blocs élémentaires 510 du module mémoire.

Le circuit 520 est en outre adapté à contrôler la lecture et l'écriture de données, ainsi que la mise en oeuvre d'opérations de calcul, dans les circuits mémoire 511 des blocs élémentaires 510 du module mémoire. Pour cela, un bus de distribution TDI interne au module 500 relie le circuit 520 à des ports d'entrée-sortie de données, d'adresse, et de contrôle (non détaillés sur la figure) des circuits mémoire 511 des différents blocs élémentaires 510 du module mémoire.

Le module 500 comprend en outre un circuit 530 (GPD) de régulation globale des accès, ainsi qu'un circuit 540 (CSRs) de registres de configuration.

Le circuit 530 est relié au circuit 207 de distribution des instructions via la liaison 209. Le circuit 530 est adapté à ordonnancer les accès aux blocs élémentaires 510 du circuit mémoire, pour éviter des conflits d'adresses lors de l'exécution des instructions reçues du processeur 231 (via le circuit 207). Pour cela, le circuit 530 reçoit les instructions provenant du processeur (via le circuit 207), et est adapté à insérer un ou plusieurs cycles d'attente entre différentes étapes d'une même instruction lorsqu'un conflit potentiel est détecté. Le circuit 530 est notamment adapté à envoyer des données de contrôle au circuit 520, via un bus de contrôle référencé Control sur la figure 5. Le circuit 530 est en outre adapté à échanger des données de contrôle avec le circuit d'arbitrage 309 du module 200. Ces échanges sont similaires aux échanges décrits précédemment entre le circuit d'arbitrage 309 et le circuit de contrôle 205 (figure 3). Dans l'exemple de la figure 5, les données échangées entre le circuit d'arbitrage 309 et le circuit de contrôle 530 peuvent en outre comprendre des données de configuration de la matrice de blocs élémentaires 510. De telles données de configuration de la matrice de blocs élémentaires 510, notamment la taille des vecteurs de données, peuvent être indiquées dans les instructions envoyées par le processeur 231 au circuit de transfert direct 203, par exemple lors de l'écriture des instructions dans le registre 301. En outre, le circuit logique 305 peut indiquer au circuit d'arbitrage 309 une taille de données à considérer lors d'une opération d'écriture ou de lecture dans le circuit mémoire 500 demandée par le circuit logique 305.

Le circuit 540 est adapté à stocker des données de configuration utilisées par le circuit 520 pour configurer les circuits de transfert vertical 513. Le circuit 520 est adapté à lire des données dans le circuit de registres 540. Le circuit 530 est adapté à lire et écrire des données dans le circuit de registres 540.

Un avantage du module mémoire 500 de la figure 5 est que l'on peut, par l'intermédiaire du circuit de contrôle 520 et des circuits de transfert vertical 513, reconfigurer virtuellement la matrice de blocs élémentaires 510, soit de façon à étendre la dimension maximale des vecteurs horizontaux pouvant être traités par le module mémoire, notamment pour la mise en oeuvre d'opérations de calcul, soit de façon à augmenter le nombre de vecteurs pouvant être traités (en réduisant la dimension maximale desdits vecteurs horizontaux).

Dans cet exemple, la liaison interne 204 du module 200 relie le circuit buffer 303 du circuit d'accès direct 203 à un port d'entrée/sortie (non détaillé sur la figure) du module reconfigurable 500.

Dans l'exemple représenté, un circuit buffer 560 fait interface entre la liaison 204 et le port d'entrée/sortie du module 500. Le buffer 560 peut, le cas échéant, permettre d'adapter la taille des données entre la liaison 204 et le port d'entrée/sortie du module 500.

Dans cet exemple, le circuit d'arbitrage 309 est adapté à échanger des signaux de synchronisation avec le circuit de transfert de données 203, comme précédemment décrit. A titre d'exemple, le buffer 560 contient un vecteur de données prêt à être écrit dans le module 500. Le circuit logique 305 envoie une requête d'opération élémentaire, ici une écriture, au circuit d'arbitrage. Le circuit d'arbitrage 309 autorise, quand cela est possible, l'écriture dudit vecteur de données prêt dans le registre 560 en envoyant un signal de contrôle, type acquittement, au circuit logique 305. Le circuit logique 305 commande le circuit buffer 303 afin de lire ledit vecteur de données dans le circuit BUF 303 et de l'écrire dans le registre 560. Le circuit d'arbitrage 309 envoie ensuite un signal d'instruction au circuit de contrôle 530 du module 500, qui commande l'écriture dans le module 500 du vecteur de données présent dans le registre 560. Un processus similaire inverse peut être prévu dans le cas où l'on souhaite lire un vecteur de données dans le circuit mémoire 500 pour le transférer dans le circuit buffer 303.

On notera que divers modes de commande du circuit buffer peuvent être envisagés, notamment pour la réalisation d'opérations de réarrangement. On pourra par exemple s'inspirer des exemples donnés dans les brevets EP2476061, EP2320325 et FR1757998 déposés par la demanderesse.

En outre, dans les exemples susmentionnés, le circuit d'arbitrage échange des signaux de requêtes et d'acquittement avec le circuit logique 305. D'autres variantes de fonctionnement peuvent être envisagées, en utilisant par exemple des registres de requête ou d'acquittement, par exemple présents dans la continuité des registres 301. De plus, il peut être envisagé des mécanismes d'échange direct de signaux entre le circuit d'arbitrage 309 et le circuit buffer 303, notamment pour synchroniser le transfert de données à travers la liaison 204, et l'écriture des données dans les registres destinataires côté circuit buffer, ou côté circuit mémoire 500, notamment le registre 560.

Là encore, un avantage du circuit d'accès direct 203 est de permettre des transferts directs de données depuis ou vers la matrice de modules élémentaires 510 du module mémoire 500, sans bloquer l'accès au processeur. En outre, la présence de la liaison interne 204 permet d'éviter d'utiliser un bus système pour faire transiter les données entre le circuit buffer 303 et le circuit mémoire 500. Cette liaison interne 204 est ainsi une liaison directe entre le circuit de transfert direct 303 et le circuit mémoire, dans le sens où elle n'utilise pas les ressources d'échange de données partagées avec les autres éléments du circuit. Cette liaison interne directe est en quelque sorte une liaison « privée » entre le circuit mémoire et le circuit de transfert direct. Cette liaison interne 204 directe, peut en pratique être réalisée par de simples fils reliant deux registres, un registre côté circuit mémoire et un registre côté circuit transfert de données 203, par exemple un registre d'entrée du circuit buffer 303. Cette liaison directe peut éventuellement comprendre des éléments de type « buffer » pour amplifier, ou relayer les signaux transitant sur la liaison directe. En outre, la liaison directe peut éventuellement inclure des éléments type porte logique pour permettre de réaliser d'éventuelles fonctions de synchronisation ou de réinitialisation de la liaison directe, notamment à proximité des entrées/sorties du circuit mémoire 201, 500 ou du circuit de transfert direct 203.

Par ailleurs, dans les exemples précédents, nous avons décrit des transferts de données entre le circuit mémoire 201 et un circuit mémoire externe 253. Selon une variante de réalisation, il est possible de prévoir des instructions émises par le processeur pour le circuit de transfert direct 203 visant à réaliser un transfert de données entre deux emplacements du circuit mémoire 201, 500. Dans ce cas, les données lues dans le circuit mémoire 201 transitent temporairement dans le circuit buffer 303 avant d'être écrites à nouveau dans le circuit mémoire dans un autre emplacement. Un tel transfert peut permettre en outre au passage de réagencer les données dans un ordre, une organisation spatiale différente, afin par exemple de faciliter la mise en oeuvre subséquente d'une opération de calcul sur ces données.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de valeurs numériques mentionnés dans la présente description.

Enfin, la mise en oeuvre pratique des modes de réalisation et variantes décrits est à la portée de la personne du métier à partir des indications fonctionnelles données ci-dessus. En particulier, la réalisation des différents éléments fonctionnels des systèmes décrits sont à la portée de la personne du métier à partir des indications de la présente description.

## Revendications

1. Dispositif mémoire (200) comportant :
- un port (233) de connexion du dispositif (200) à un processeur (231) ;
- un circuit mémoire (201 ; 511) adapté à mettre en œuvre des opérations de calcul et à réaliser des opérations élémentaires incluant une lecture, une écriture ou un calcul ;
- un premier circuit (205 ; 530) de contrôle adapté à recevoir des premières instructions en provenance du processeur (231) via ledit port (233), et à décomposer chaque première instruction reçue en une séquence d'une ou de plusieurs opérations élémentaires de façon à générer un premier flux de requête d'opérations élémentaires;
- un circuit (203) de transfert direct de données depuis ou vers ledit circuit mémoire (201 ; 511), le circuit de transfert direct (203) étant adapté à recevoir des deuxièmes instructions en provenance du processeur (231) via ledit port (233), à décomposer chaque deuxième instruction reçue en une séquence de plusieurs opérations élémentaires à réaliser dans ledit circuit mémoire de façon à générer un deuxième flux de requête d'opérations élémentaires;
- une liaison interne (204) d'échange de données reliant directement ledit circuit mémoire (201 ; 511) au circuit de transfert direct (203) ; et
- un circuit d'arbitrage (309) adapté à recevoir les premier et deuxième flux de requête d'opérations élémentaires et à commander le premier circuit de contrôle (205 ; 530) pour exécuter un unique flux global de requête d'opérations élémentaires dans le circuit mémoire en mettant en oeuvre des règles de priorité prédéfinies dans le cas de requêtes simultanées d'accès au circuit mémoire, dans lequel la liaison interne (204) a une largeur de données supérieure à la largeur de données du port (233) de connexion du dispositif (200) au processeur (231).

2. Dispositif mémoire (200) selon la revendication 1, dans lequel le circuit de transfert direct (203) comprend un circuit buffer (303) adapté à stocker temporairement des données transitant depuis ou vers ledit circuit mémoire (201 ; 500).

3. Dispositif mémoire (200) selon la revendication 1 ou 2, comprenant un circuit de distribution (207) connecté audit port de connexion du dispositif (200) au processeur (231), le circuit de distribution (207) recevant les premières et deuxièmes instructions en provenance du processeur (231) et étant adapté à transmettre les premières instructions au premier circuit de contrôle (205) et les deuxièmes instructions au circuit de transfert direct (203), le circuit de distribution utilisant une information d'adresse présente dans l'instruction pour réaliser cette distribution.

4. Dispositif mémoire (200) selon l'une quelconque des revendications 1 à 3, dans lequel la liaison interne (204) a une largeur de données égale à la taille du plus grand vecteur de données pouvant être lu en une fois dans ledit circuit mémoire (201 ; 511).

5. Dispositif mémoire (200) selon l'une quelconque des revendications 1 à 4, dans lequel la liaison interne (204) a une largeur de données au moins deux fois supérieure à la largeur de données du port de connexion (233) du dispositif (200) au processeur (231).

6. Dispositif mémoire (200) selon l'une quelconque des revendications 1 à 5, dans lequel le circuit de transfert direct (203) est connecté à un port de connexion du module (200) à un bus système mémoire (251) externe au dispositif (200) .

7. Dispositif mémoire (200) selon la revendication 6, dans lequel le port de connexion du dispositif (200) au bus système mémoire (251) présente une largeur de données supérieure à la largeur de données du port de connexion (233) du dispositif (200) au processeur (231).

8. Dispositif mémoire (200) selon la revendication 6 ou 7 dans son rattachement à la revendication 2, dans lequel le circuit buffer (303) du circuit de transfert direct (203) est adapté à stocker temporairement des données transitant entre ledit circuit mémoire (201 ; 500) et un circuit mémoire externe (253) relié audit bus système mémoire (251).

9. Dispositif mémoire (200) selon l'une quelconque des revendications 1 à 8, dans lequel le circuit de transfert direct (203) comprend des registres de configuration (301) stockant les deuxièmes instructions reçues en provenance du processeur (231).

10. Dispositif mémoire (200) selon les revendications 8 et 9, dans lequel le circuit de transfert direct (203) comprend en outre un deuxième circuit de contrôle (305) adapté à lire et écrire dans les registres de configuration (301), à échanger des données de contrôle avec le circuit d'arbitrage (309), et à commander des transferts de données via le circuit buffer (303).

11. Dispositif mémoire (200) selon l'une quelconque des revendications 1 à 10, dans lequel ledit circuit mémoire comprend une pluralité de circuits mémoire (511) adaptés à mettre en oeuvre des opérations de calcul, lesdits circuits mémoire (511) étant agencés en matrice selon des rangées et des colonnes.

12. Dispositif mémoire (200) selon la revendication 11, dans lequel la matrice de circuits mémoire (511) est reconfigurable de façon à ajuster la dimension des vecteurs de données dans la direction des rangées.

13. Système comportant un dispositif mémoire (200) selon l'une quelconque des revendications 1 à 12, un processeur (231) adapté à transmettre les premières et deuxièmes instructions au dispositif mémoire (200), un bus système mémoire (251) relié au circuit de transfert direct (203) du dispositif mémoire (200), et un circuit mémoire externe (253) relié au bus système mémoire (251), dans lequel le circuit de transfert direct (203) est adapté à transférer des données directement entre le circuit mémoire (201) du dispositif (200) et le circuit mémoire externe (253) via le bus système mémoire (251), sans passer par le processeur (231) .
